# EUROPÄISCHE PATENTSCHRIFT

(11) **EP 0 482 541 B1**
(45) Veröffentlichungstag und Bekanntmachung des Hinweises auf die Patenterteilung: **31.07.1996**
(21) Anmeldenummer: 91117893.7
(22) Anmeldetag: 21.10.1991
(51) Int. Cl.: H01J 37/32, C23C 16/50, H01J 37/20, H01L 21/00

(54) **Grossflächige Kathodenanordnung mit gleichmässigem Abbrandverhalten**
Large area cathodic device with equalized consumption
Dispositif cathodique de grande surface à consommation régulièrement répartie

(30) Priorität: 26.10.1990 DE 9014857 U
(43) Veröffentlichungstag der Anmeldung: 29.04.1992
(73) Patentinhaber: METAPLAS IONON Oberflächenveredelungstechnik GmbH, D-51427 Bergisch Gladbach (DE)
(72) Erfinder: Cremer, Dieter, W-5063 Overath 8 (DE); Dederichs, Hans-Gerhard, W-5000 Köln 80 (DE)
(74) Vertreter: Stenger, Watzke & Ring Patentanwälte

(56) Entgegenhaltungen:
- EP-A- 0 393 344
- DE-A- 3 603 646
- GB-A- 2 161 837
- PATENT ABSTRACTS OF JAPAN vol. 14, no. 244 (E-932)(4187) 24. Mai 1990 & JP-A- 02 068 847 ( NTT ) 8. März 1990

## Beschreibung

Die Erfindung betrifft eine Anordnung von großflächigen Kathoden in Beschichtungsanlagen, vorzugsweise in PVD-Beschichtungsanlagen, mit einer durch Zufuhr von elektrischem Strom abbrennbaren Kathodenplatte, die an einer Grundplatte, ggf. mittels einer elektrisch und thermisch gut leitenden Zwischenplatte befestigt und durch ein Kühlmittel gekühlt ist, das Kühlkanäle in der Grundplatte bzw. Zwischenplatte durchströmt.

Derartige Anordnungen von großflächigen Kathoden in Beschichtungsanlagen sind beispielsweise aus der EP-A-0 393 344 bekannt. Die Kathodenplatte dient als Quelle zumindest eines Teiles des als Beschichtung vorgesehenen Materials. Insbesondere werden solche beispielsweise aus Titan, Chrom, Titan-Aluminium und Titan-Zircon hergestellte Kathoden zur Beschichtung von Werkstücken verwendet. Beim Betrieb derartiger Beschichtungsanlagen werden die Kathodenplatten mit großen Strömen beaufschlagt, um einen elektrischen Lichtbogen entstehen zu lassen, der je nach Beschichtungsverfahren noch durch Magnetfelder beeinflußt wird.

Bei den bekannten Beschichtungsverfahren und Beschichtungsanlagen brennen die Kathodenplatten ungleichmäßig ab, so daß ihre Standzeit kürzer als die theoretisch mögliche Standzeit ist. Bisherige Versuche, das Abbrandverhalten durch verschiedene Maßnahmen, beispielsweise statische Magnetfelder, zu beeinflussen, haben zwar zur Verbesserungen geführt, ohne jedoch einen verstärkten Abbrand der Kathodenplatte in einzelnen Bereichen zu vermeiden.

Der Erfindung liegt die **Aufgabe** zugrunde, eine Anordnung von großflächigen Kathoden in Beschichtungsanlagen der eingangs beschriebenen Art zu schaffen, mit der ein möglichst gleichmäßiger Abbrand der Kathodenplatte erzielt wird.

Die **Lösung** dieser Aufgabenstellung durch die Erfindung ist dadurch gekennzeichnet, daß eine Mehrzahl von mit der Grundplatte und/oder der Zwischenplatte verbundenen Stromzuführungsleitungen für die Stromzufuhr angeordnet ist.

Durch die erfindungsgemäße Anordnung einer Mehrzahl von Stromzuführungsleitungen ergibt sich eine gleichmäßige Verteilung der elektrischen Stromdichte bzw. des elektrischen Potentials in der Kathodenplatte, so daß ein ungleichmäßiger Abbrand infolge ungleichmäßiger Verteilung der Stromdichte innerhalb der Kathodenplatte vermieden wird. Mit der Erfindung wird somit eine erheblich längere Standzeit der Kathodenplatten und gleichzeitig eine Verbesserung der Beschichtungsqualität erreicht.

Gemäß einem weiteren Merkmal der Erfindung sind die Stromzuführungsleitungen etwa gleichmäßig über die Fläche der Grundplatte und/oder der Zwischenplatte verteilt.

Bei bekannten Anordnungen aus einer Grundplatte und einer Zwischenplatte, die aus Kupfer oder einer Kupferlegierung besteht und U-förmig oder mäanderförmig verlaufende Kühlkanäle aufweist, wird mit der Erfindung vorgeschlagen, daß die Zwischenplatte an der der Kathodenplatte zugewandten Seite eine durchgehende Wand, vorzugsweise mit einer Wanddicke von 2 bis 8 mm aufweist und die Kühlkanäle auf der der Grundplatte zugewandten Seite angeordnet und von der Grundplatte begrenzt sind. Bei dieser Ausgestaltung trägt die der Kathodenplatte zugewandte durchgehende Wand der Zwischenplatte zur Vergleichmäßigung der Stromverteilung bei und verhindert außerdem, daß Kühlmittel in die Beschichtungsanlage gelangen kann, wenn die Kathodenplatte an einer Stelle vollständig abgetragen ist oder Undichtigkeiten auftreten.

Erfindungsgemäß werden die Stromzuführungsstellen so gewählt, daß die Zwischenplatte unter Berücksichtigung des Verlaufs der Kühlkanäle gleichmäßig mit Strom beaufschlagt ist. Hierbei kann zumindest ein Teil der Stromzuführungsstellen im äußeren, nicht mehr von Kühlkanälen umschlossenen Bereich der Zwischenplatte liegen. Hierdurch wird ein Abbrand der Kathodenplatte auch in den äußeren Bereichen erzielt.

Bei den üblichen rechteckigen Kathodenplatten mit zwei Langseiten und zwei Schmalseiten wird schließlich vorgeschlagen, jeweils mindestens eine Stromzuführungsstelle in der Nähe jeder Schmalseite anzuordnen.

Auf der Zeichnung ist ein Ausführungsbeispiel der erfindungsgemäßen Anordnung von großflächigen Kathoden in Beschichtungsanlagen dargestellt, und zwar zeigen:
- Fig. 1: einen Längsschnitt durch eine Anordnung mit rechteckiger Kathodenplatte gemäß der Schnittlinie I-I in den Fig. 2 und 4,
- Fig. 2: eine Ansicht der Außenseite der Anordnung nach Fig. 1,

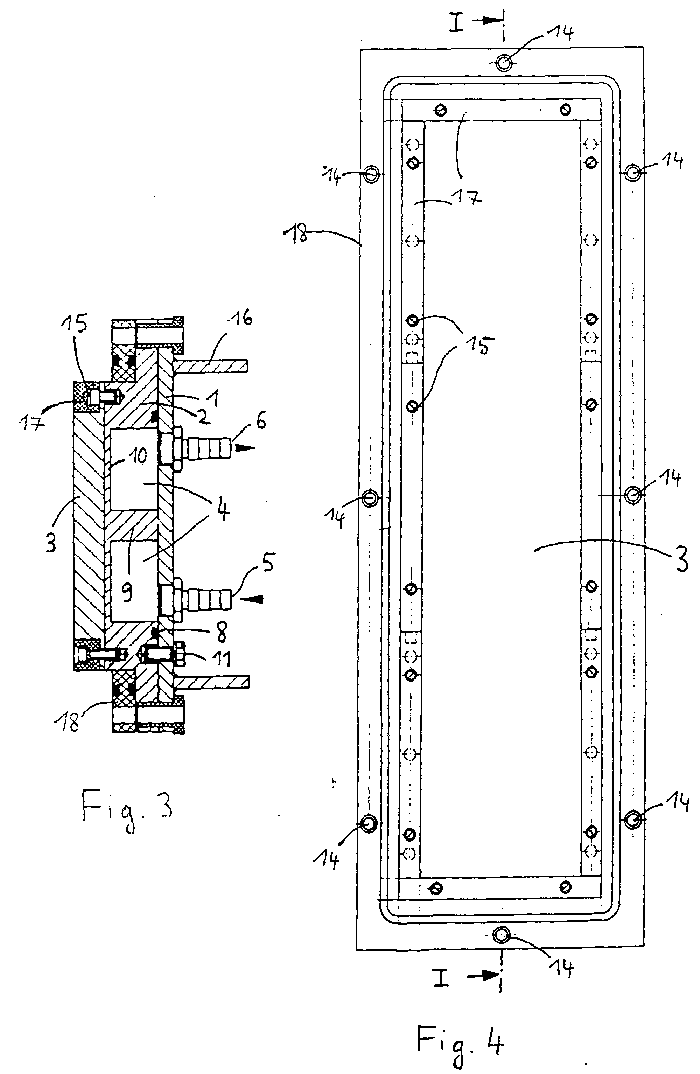

- Fig. 3: einen Querschnitt gemäß der Schnittlinie III - III in Fig. 2 und
- Fig. 4: eine Ansicht der Kathodenseite der Anordnung.

(Es folgt jetzt die Figurenbeschreibung gemäß Spalte 3, Zeile 18 bis Spalte 4, Zeile 19 der EP 0 482 541 A1).

Die Anordnung ist schichtweise aufgebaut aus einer Grundplatte 1, einer elektrisch und thermisch gut leitenden Zwischenplatte 2, vorzugsweise aus Kupfer oder einer Kupferlegierung, und der eigentlichen Kathodenplatte 3, welche aus dem zu verdampfenden Material, beispielsweise Titan, besteht. Die Kathodenplatte ist in üblicher Weise mittels nicht näher beschriebener Halterungen 17 und Kathodenhalteschrauben 15 flächig glatt anliegend an der Zwischenplatte 2 befestigt. Die Zwischenplatte 2 weist eine an der Kathodenplatte 3 anliegende durchgehende Wand 10 auf und ist an ihrer der Grundplatte 1 zugewandten Seite von Kühlkanälen 4 unterbrochen. Im vorliegenden Fall verlaufen die Kühlkanäle 4 U-förmig und sind durch einen Mittelsteg 9 getrennt. In der Zwischenplatte 2 ist eine Dichtungsnut 7 vorgesehen, in welcher eine. Dichtung 8 liegt, mit der eine dichte Verbindung zwischen Grundplatte 1 und Zwischenplatte 2 erzielt wird. In der Grundplatte 1 sind ein Kühlmittelzulauf 5 und ein Kühlmittelablauf 6 angeordnet. Grundplatte 1 und Zwischenplatte 2 sind mittels Halteschrauben 11 fest miteinander verbunden. Die gesamte Kathodenanordnung kann mittels eines nicht näher beschriebenen Rahmens 18 und mit Hilfe von Befestigungsschrauben 14 dichtend mit der Wand einer Beschichtungsanlage verschraubt werden, so daß die Kathode im Inneren der Beschichtungsanlage liegt. Verstärkungsrippen 16 sorgen für die notwendige Formstabilität der gesamten Anordnung.

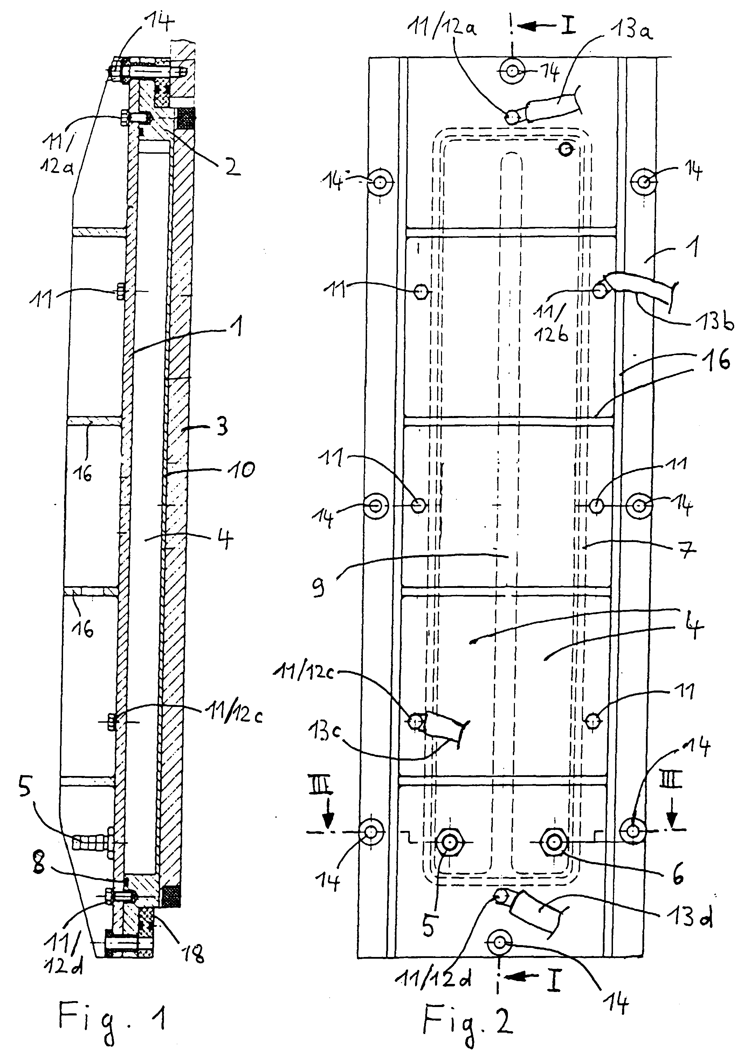

Die Stromzuführung zu der Kathodenanordnung erfolgt über Stromzuleitungen 13a, b, c, d, wobei im vorliegenden Ausführungsbeispiel diese Stromzuleitungen an einem Teil der Halteschrauben 11 befestigt ist, da dies den Montageaufwand verringert. Notwendig ist dies jedoch nicht, so daß auch gesonderte Befestigungen gewählt werden könnten. Wichtig ist, daß die Stromzuführungsstellen 12a, b, c, d, die im vorliegenden Falle teilweise mit den Halteschrauben 11 zusammenfallen, gleichmäßig über die Fläche der Anordnung verteilt sind. Dabei sollte die Stromverteilung im Hinblick auf die Lage der Kühlkanäle zusätzlich berücksichtigt werden, obwohl die durchgehende Wand 10 der Zwischenplatte 2 geringfügige Ungleichmäßigkeiten bei der Stromzuführung noch weitgehend ausgleichen kann. Im vorliegenden Ausführungsbeispiel liegen die Stromzuführungsstellen 12a, d im Bereich der Schmalseite der Anordnung, wobei die Stromzuführungsstelle 12d besonders günstig im Hinblick auf eine Einleitung von Strom in den Mittelsteg 9 angeordnet ist. Die Stromzuführungsstellen 12a, b, c, d liegen alle außerhalb der (in Figur 2 gestrichelt angedeuteten) Dichtungsnut 7 und damit im massiven Bereich der Zwischenplatte 2.

Die vorliegende Erfindung eignet sich insbesondere für Kathoden von PVD-Beschichtungsanlagen, ist jedoch nicht auf solche Anwendungen beschränkt.

## Patentansprüche

1. Anordnung von großflächigen Kathoden in Beschichtungsanlagen, vorzugsweise in PVD-Beschichtungsanlagen, mit einer durch Zufuhr von elektrischem Strom abbrennbaren Kathodenplatte (3), die an einer Grundplatte (1), ggf. mittels einer elektrisch und thermisch gut leitenden Zwischenplatte (2) befestigt und durch Kühlmittel gekühlt ist, das Kühlkanäle (4) in der Grundplatte (1) bzw. Zwischenplatte (2) durchströmt,
**dadurch gekennzeichnet**,
daß zur gleichmäßigen Verteilung der elektrischen Stromdichte bzw. des elektrischen Potentials in der Kathodenplatte (3) eine Mehrzahl von mit der Grundplatte (1) und/oder der Zwischenplatte (2) verbundenen Stromzuführungsleitungen (13a,13b,13c,13d) für die Stromzufuhr angeordnet ist.

2. Anordnung nach Anspruch 1, dadurch gekennzeichnet, daß die Stromzuführungsleitungen (13a,13b,13c,13d) etwa gleichmäßig über die Fläche der Grundplatte (1) und/oder Zwischenplatte (2) verteilt sind.

3. Anordnung nach Anspruch 1 oder 2 mit einer Grundplatte (1) und einer Zwischenplatte (2), die aus Kupfer oder einer Kupferlegierung besteht und mit U-förmig oder meanderförmig verlaufenden Kühlkanälen (4) versehen ist, dadurch gekennzeichnet, daß die Zwischenplatte (2) an der der Kathodenplatte (3) zugewandten Seite eine durchgehende Wand (10), vorzugsweise mit einer Wanddicke von 2 bis 8 mm aufweist und die Kühlkanäle (4) auf der der Grundplatte (1) zugewandten Seite angeordnet und von der Grundplatte (1) begrenzt sind.

4. Anordnung nach Anspruch 3, dadurch gekennzeichnet, daß die Stromzuführungsstellen (12a,12b,12c,12d) so gewählt sind, daß die Zwischenplatte (2) unter Berücksichtigung des Verlaufs der Kühlkanäle (4) gleichmäßig mit Strom beaufschlagt ist.

5. Anordnung nach Anspruch 4, dadurch gekennzeichnet, daß zumindest ein Teil der Stromzuführungsstellen (12a,12b,12c,12d) im äußeren, nicht mehr von Kühlkanälen (4) umschlossenen Bereich der Zwischenplatte (2) liegt.

6. Anordnung nach einem der vorhergehenden Ansprüche mit einer rechteckigen Kathodenplatte (3) mit zwei Langseiten und zwei Schmalseiten, dadurch gekennzeichnet, daß jeweils mindestens eine Stromzuführungsstelle (12a,12d) in der Nähe jeder Schmalseite vorhanden ist.

## Claims

1. Arrangement of large-area cathodes in coating installations, preferably in PVD coating installations, having a cathode plate (3) which can be consumed by the supply of electric current, is fastened to a baseplate (1), if appropriate by means of an intermediate plate (2) which is readily conductive both electrically and thermally, and is cooled by coolant which flows through cooling channels (4) in the baseplate (1) and/or intermediate plate (2), characterized in that, for the uniform distribution of the electrical current density or of the electrical potential in the cathode plate (3), there are arranged a plurality of power supply lines (13a, 13b, 13c, 13d) for the current supply, which are connected to the baseplate (1) and/or the intermediate plate (2).

2. Arrangement according to Claim 1, characterized in that the power supply lines (13a, 13b, 13c, 13d) are distributed approximately uniformly over the area of the baseplate (1) and/or intermediate plate (2).

3. Arrangement according to Claim 1 or 2, having a baseplate (1) and an intermediate plate (2), which is composed of copper or a copper alloy and is provided with cooling channels (4) having a U-shaped or meandering course, characterized in that, on that side facing the cathode plate (3), the intermediate plate (2) has a continuous wall (10), preferably having a wall thickness of 2 to 8 mm, and the cooling channels (4) are arranged on that side facing the baseplate (1) and are bounded by the baseplate (1).

4. Arrangement according to Claim 3, characterized in that the power supply points (12a, 12b, 12c, 12d) are chosen in such a way that current is applied uniformly to the intermediate plate (2) while taking account of the course of the cooling channels (4).

5. Arrangement according to Claim 4, characterized in that at least some of the power supply points (12a, 12b, 12c, 12d) are situated in the outer region, no longer enclosed by cooling channels (4), of the intermediate plate (2).

6. Arrangement according to one of the preceding claims, having a rectangular cathode plate (3) having two long sides and two narrow sides, characterized in that at least one power supply point (12a, 12d) is in each case present in the vicinity of each narrow side.

## Revendications

1. Dispositif cathodique de grande surface dans des installations d'enduction, de préférence dans des installations d'enduction par déposition en phase gazeuse par procédé physique (PVD), comprenant une plaque de cathode (3) qui peut être consumée par l'apport de courant électrique et qui est fixée à une plaque de base (1), le cas échéant au moyen d'une plaque intermédiaire (2) à bonne conductibilité électrique et thermique, et est refroidie par un agent réfrigérant parcourant des canaux de refroidissement (4) ménagés dans la plaque de base (1) ou, respectivement, dans la plaque intermédiaire (2), caractérisé en ce que, pour obtenir une répartition uniforme de la densité du courant électrique ou du potentiel électrique dans la plaque de cathode (3), une pluralité de lignes d'alimentation en courant (13a, 13b, 13c, 13d) connectées à la plaque de base (1) et/ou à la plaque intermédiaire (2) sont prévues pour amener du courant.

2. Dispositif selon la revendication 1, caractérisé en ce que les lignes d'alimentation en courant (13a, 13b, 13c, 13d) sont réparties de manière sensiblement uniforme à la surface de la plaque de base (1) et/ou de la plaque intermédiaire (2).

3. Dispositif selon la revendication 1 ou 2, comprenant une plaque de base (1) et une plaque intermédiaire (2) qui est réalisée en cuivre ou en alliage de cuivre et comporte des canaux de refroidissement (4) en forme de U ou de méandres, caractérisé en ce que la plaque intermédiaire (2) comporte, sur sa face tournée vers la plaque de cathode (3), une paroi continue (10) d'une épaisseur comprise de préférence entre 2 et 8 mm, et en ce que les canaux de refroidissement (4) se trouvent sur la face tournée vers la plaque de base (1) et sont délimités par la plaque de base (1).

4. Dispositif selon la revendication 3, caractérisé en ce que les points d'alimentation en courant (12a, 12b, 12c, 12d) sont choisis de façon que la plaque intermédiaire (2) soit soumise uniformément au courant en tenant compte du tracé des canaux de refroidissement (4).

5. Dispositif selon la revendication 4, caractérisé en ce qu'au moins une partie des points d'alimentation en courant (12a, 12b, 12c, 12d) se trouve dans la zone extérieure de la plaque intermédiaire (2), ladite zone n'étant plus entourée par des canaux de refroidissement (4).

6. Dispositif selon l'une des revendications précédentes, comprenant une plaque de cathode rectangulaire (3) avec deux grands côtés et deux petits côtés, caractérisé en ce qu'au moins un point d'alimentation en courant (12a, 12d) se trouve à proximité de chaque petit côté.
